# EUROPÄISCHE PATENTSCHRIFT

(11) **EP 2 973 687 B1**
(45) Veröffentlichungstag und Bekanntmachung des Hinweises auf die Patenterteilung: **03.05.2017**
(21) Anmeldenummer: 14714161.8
(22) Anmeldetag: 11.03.2014
(51) Int. Cl.: H01L 23/14, H01L 23/538, H01L 23/367

(54) **ELEKTRONISCHES BAUTEIL, VERFAHREN ZU DESSEN HERSTELLUNG UND LEITERPLATTE MIT ELEKTRONISCHEM BAUTEIL**
ELECTRONIC SUB-ASSEMBLY, METHOD FOR THE PRODUCTION THEREOF AND PRINTED CIRCUIT BOARD HAVING AN ELECTRONIC SUB-ASSEMBLY
COMPOSANT ÉLECTRONIQUE, SON PROCÉDÉ DE FABRICATION ET CARTE DE CIRCUIT IMPRIMÉ ÉQUIPÉE D'UN COMPOSANT ÉLECTRONIQUE

(30) Priorität: 13.03.2013 DE 102013102541
(43) Veröffentlichungstag der Anmeldung: 20.01.2016
(73) Patentinhaber: Schweizer Electronic AG, 78713 Schramberg (DE)
(72) Erfinder: GOTTWALD, Thomas, 78655 Dunningen (DE); NEUMANN, Alexander, 78628 Rottweil (DE)
(74) Vertreter: Glawe, Delfs, Moll
(86) Internationale Anmeldenummer: PCT/EP2014/000631
(87) Internationale Veröffentlichungsnummer: WO 2014/139666

(56) Entgegenhaltungen:
- EP-A1- 0 121 374
- WO-A1-00/13823
- WO-A2-01/78109
- DE-A1-102010 060 855
- US-A- 4 835 598
- US-A1- 2003 127 715

## Beschreibung

Die vorliegende Erfindung betrifft ein elektronisches Bauteil sowie ein Verfahren zu dessen Herstellung.

Aus der DE 10 2009 013 818 A1 ist ein Verfahren zur Herstellung einer elektronischen Vorrichtung bekannt, bei dem nach dem Bereitstellen eines Trägers mit einer ersten leitenden Schicht über dieser ersten leitenden Schicht eine erste isolierende Schicht aufgebracht wird und mindestens eine Durchgangsverbindung von einer ersten Seite der ersten isolierenden Schicht zu einer zweiten Seite der ersten isolierenden Schicht erzeugt wird. Mindestens zwei Halbleiterchips werden an dem Träger angebracht und eine zweite isolierende Schicht wird über dem Träger aufgebracht. Dann wird die zweite isolierende Schicht geöffnet, bis der Träger freigelegt ist und eine Metallschicht wird über der geöffneten zweiten isolierenden Schicht abgeschieden, woraufhin die mindestens zwei Halbleiterchips getrennt werden.

Aus der DE 10 2010 060 855 A1 ist ein elektronisches Bauteil mit einer elektrisch leitenden Kernschicht mit einer beidseitig aufgebrachten ersten Schicht aus elektrisch leitendem Material und mit mindestens einem in einer Ausnehmung der ersten Schicht angeordneten elektronischen Bauelement bekannt. Die erste Schicht ist jeweils mit einer elektrisch isolierenden, thermisch leitfähigen Schicht bedeckt, und auf der thermisch leitfähigen Schicht ist jeweils eine weitere Schicht aus elektrisch leitendem Material vorgesehen, die jeweils mit einer Deckschicht aus elektrisch leitendem Material überzogen sind. Des weiteren sind Durchkontaktierungen aus dem Material der Deckschicht vorgesehen, die sich durch die das elektronische Bauelement bedeckende elektrisch isolierende, thermisch leitfähige Schicht und die weitere Schicht aus elektrisch und thermisch leitendem Material zum Ankontaktieren des elektronischen Bauelements erstrecken.

Die US 4,835,598 offenbart eine gedruckte Leiterplatte zum Tragen eines Halbleiterchips mit einem Grundsubstrat aus Harz mit mindestens einer Öffnung darin, in die eine wärmeleitfähige Platte zur Chipbestückung eingesetzt ist, wobei eine isolierende Haftschicht zumindest eine Seite des Substrats und einen auf der Schicht ausgebildeten elektrischen Schaltkreis bedeckt.

Die EP 0 121 374 A1 offenbart einen auf einem Substrat angebrachten Halbleiterchip, der in einer Ausnehmung angeordnet ist, die von einer Schicht aus Glaskeramikmaterial mit im wesentlichen der gleichen Dicke wie derjenigen des Chips umgeben ist. Das Substrat besteht aus Kupfer oder aus einem anderen Material mit einer ähnlich hohen thermischen Leitfähigkeit und umfasst eine Mehrzahl von eng beabstandeten Säulen, um erzeugte Wärme besser abzuleiten und andererseits ungewünschte Beanspruchungen und Belastungen zu vermeiden.

Die DE 10 2010 060 855 A1 offenbart ein elektronisches Bauteil mit einer elektrisch leitenden Kernschicht mit einer beidseitig aufgebrachten ersten Schicht aus elektrisch leitendem Material und mit mindestens einem in einer Ausnehmung der ersten Schicht angeordneten elektronischen Bauelement, wobei die erste Schicht jeweils mit einer elektrisch isolierenden, thermisch leitfähigen Schicht bedeckt ist und auf der thermisch leitfähigen Schicht jeweils eine weitere Schicht aus elektrisch leitendem Material vorgesehen ist, die jeweils mit einer Deckschicht aus elektrisch leitendem Material überzogen sind. Eine Verkapselung ist nicht vorgesehen.

Demgegenüber wird erfindungsgemäß ein elektronisches Bauteil mit den Merkmalen des Anspruchs 1 , ein Verfahren zu deren Herstellung mit den Merkmalen des Anspruchs 8 sowie eine Leiterplatte mit einem erfindungsgemäßen elektronischen Bauteil gemäß Anspruch 15 angegeben.

Der Grundgedanke der Erfindung besteht darin, für ein elektronisches Bauteil eine Trägerschicht zur Verfügung zu stellen, deren thermischer Ausdehnungskoeffizient an denjenigen des zu bestückenden (d.h. des aufzubringenden) elektronischen Bauelements (wie bspw. Chip) angepasst ist. Erfindungsgemäß ist somit die Differenz der thermischen Ausdehnungskoeffizienten zwischen dem Substrat und dem bzw. den Chips verringert, woraus eine Steigerung der Zuverlässigkeit resultiert. Das erfindungsgemäße elektronische Bauteil stellt gegenüber dem Stand der Technik eine kostengünstige und auch zuverlässigere Alternative dar.

Erreicht wird dies durch die Verwendung anderer Materialien für die Trägerschicht des elektronischen Bauteils. Das Auswahlkriterium für das Material der Trägerschicht ist ein geringer Wärmeausdehnungskoeffizient, um eine hohe Dimensionsstabilität der Kernschicht bei Temperaturänderungen, wie sie bspw. beim Löten auftreten, zu erzielen. Unter einem "geringen Wärmeausdehnungskoeffizienten" im Sinne der vorliegenden Erfindung ist ein zumindest temperaturabschnittsweise (also in bestimmten Temperaturbereichen) auftretender besonders oder sogar anomal kleiner Wärmeausdehnungskoeffizient. Ein Beispiel hierfür ist die Eisen-Nickel-Legierung FeNi36, auch bekannt unter dem Handelsnamen Invar®. Dem Fachmann sind jedoch weitere Legierungen bekannt, die die beschriebenen Bedingungen erfüllen, wie bspw. Fe65Ni35 oder Fe-33Ni-4.5Co, das durch Legieren von ca. 5 % Cobalt einen weiter verringerten Ausdehnungskoeffizienten aufweist. Auch Kupfer-Molybdän-Legierungen sind möglich. Im Handel sind bspw. Inovco® oder Kovar® bekannt. In diesem Zusammenhang spricht der Fachmann auch von "CTE-angepassten Legierungen".

Erfindungsgemäß findet eine Anpassung des Wärmeausdehnungskoeffizienten der Kernschicht an das zur Bestückung vorgesehene elektronische Bauelement statt. Eine derartige Anpassung kann durch eine Optimierung einerseits des geringen Ausdehnungskoeffizienten, der in Richtung erhöhte Lebensdauer wirkt, und andererseits der elektrischen und thermischen Eigenschaften, um das Bauteil mit hoher Leistung betreiben zu können, erfolgen. Invar ist ein schlechter thermischer und elektrischer Leiter

Für die erfindungsgemäße Ausgestaltung der Trägerschicht bieten sich mehrere Varianten an: Eine Kernschicht aus elektrisch leitfähigem Material kann mit einer Schicht aus einem Material mit einem geringen Wärmeausdehnungskoeffizienten beschichtet werden. Eine weitere Variante sieht vor, dass eine Kernschicht aus einem Material mit einem geringen Wärmeausdehnungskoeffizienten mit einer Schicht aus elektrisch leitfähigem Material beschichtet wird. Schließlich ist es auch möglich, eine Kernschicht aus einem elektrisch leitfähigen Material zumindest abschnittsweise mit einem Material mit einem geringen Wärmeausdehnungskoeffizienten zu durchsetzen, oder umgekehrt. Für dieses Durchsetzen bietet sich insbesondere der Bestückungsbereich der Trägerschicht an, auf den in einem späteren Bestückungsschritt das elektronische Bauelement angeordnet wird, auf das der Gesamt-Wärmeausdehnungskoeffizient ausgerichtet ist. Diese Varianten können auch kombiniert werden.

Die Kernschicht aus dem Material mit geringem Wärmeausdehnungskoeffizienten wird in mindestens einem Bestückungsbereich mit mindestens einem elektronischen Bauelement, wie bspw. einem Leistungshalbleiter o.dgl. bestückt. Alternativ wird die Kernschicht vor der Bestückung beidseitig mit einer elektrisch leitenden ersten Schicht plattiert. Dieses Plattieren kann bei einigen Kernschichtmaterialien notwendig oder vorteilhaft sein, bei anderen Materialien ist es u.U. nicht notwendig. Das Material der auf die Kernschicht aufgebrachten ersten Schicht (oder auch Plattierungsschicht) hat (zumindest temperaturabschnittsweise) einen höheren Wärmeausdehnungskoeffizienten als die Kernschicht. In der Regel handelt es sich bei dem Material der ersten Schicht um Kupfer, aber auch andere dem Fachmann geläufige geeignete Materialien können Verwendung finden.

Umgekehrt kann auf eine Kernschicht aus z.B. Kupfer mit hohem Ausdehnungskoeffizienten auch eine erste Schicht, wie bspw. FeNi36, abgeschieden werden, deren Ausdehnungskoeffizient geringer ist als der des Kernmaterials. Dieses Abscheiden kann z.B. galvanisch erfolgen.

Dies kann auch dadurch erreicht werden, dass bei der (galvanischen) Abscheidung Feststoffe in den (galvanischen) Überzug mit eingelagert werden, z.B. SiC, dessen Ausdehnungskoeffizient sehr niedrig liegt. Durch Einlagerung dieses Feststoffes stellt sich ein insgesamt niedrigerer Ausdehnungskoeffizient ein, als der des galvanischen Überzugs alleine. Wird während der Abscheidung der Anteil der eingelagerten Feststoffe sukzessive gesteigert, kann der Ausdehnungskoeffizient graduell von hoch nach niedrig verändert werden, was zu einer noch höheren Zuverlässigkeit des späteren Systems aus Trägerwerkstoff mit hohem Ausdehnungskoeffizienten und zu bestückendem Bauelement mit niedrigem Ausdehnungskoeffizienten führt.

Erfindungsgemäß kann durch Wahl der Dickenverhältnisse der Kernschicht zu der Plattierungsschicht eine "Feineinstellung" des Wärmeausdehnungskoeffizienten erfolgen, um diesen möglichst genau an die durch das zu bestückende elektronische Bauelement gegebenen Rahmenbedingungen anzupassen. Je niedriger der Ausdehnungskoeffizient sein soll, desto dicker wird die Kernschicht gewählt.

Die Kernschicht der Trägerschicht kann - wie bereits voranstehend erwähnt - zumindest bereichsweise bzw. abschnittsweise ein von dem Material der Kernschicht abweichendes Material aufweisen. Dies ermöglicht eine weitere "Feineinstellung" des Wärmeausdehnungskoeffizienten.

Der Bereich der Kernschicht mit einem anderen Material kann zum Beispiel unterhalb des Bestückungsbereiches vorgesehen sein.

Der Bereich der Kernschicht mit einem anderen Material kann beispielsweise durch Löcher in dem Material der Kernschicht, die durch galvanisch abgeschiedenes Kupfer (oder ein anderes geeignetes leitendes Material) gefüllt sind, gebildet sein.

Weitere Vorteile und Ausgestaltungen der Erfindung ergeben sich aus der Beschreibung und der beiliegenden Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist zur Veranschaulichung anhand von Ausführungsbeispielen in der Zeichnung schematisch und nicht maßstabsgetreu dargestellt und wird im folgenden unter Bezugnahme auf die Zeichnung ausführlich beschrieben.
Figur 1 zeigt eine Kernschicht eines erfindungsgemäßen elektronischen Bauteils.
Figur 2 zeigt die Kernschicht der Figur 1 mit beidseitig aufgebrachter erster Schicht.
Figur 3 zeigt die Schichtabfolge der Figur 2 mit einer selektiv plattierten Fläche für die Bauelementbestückung.
Figur 4 zeigt die Schichtabfolge der Figur 3 mit einem bestückten Bauelement.
Figuren 5A und 5B zeigen zwei Ausführungsvarianten einer Bauelementverkapselung.
Figuren 6A und 6B zeigen die beiden Schichtabfolgen der Figuren 5A und 5B mit aufgebrachter Ausgleichsschicht.
Figuren 7A und 7B zeigen die beiden Schichtabfolgen der Figuren Figuren 6A und 6B nach dem Verpressen.
Figuren 8A und 8B zeigen die beiden Schichtabfolgen der Figuren 7A und 7B nach den Schritten der Lochherstellung und der Durchkontaktierung.
Figur 9 veranschaulicht eine Ausführungsvariante mit einer zumindest bereichsweise aus einem anderen Material bestehender Kernschicht.
Figur 10 veranschaulicht eine Ausführungsform mit außerhalb des Bestückungsbereichs vorgesehenen Durchkontaktierungen zur Entwärmung.
Figur 11 zeigt eine Alternative zu der Ausführungsform der Figur 10.

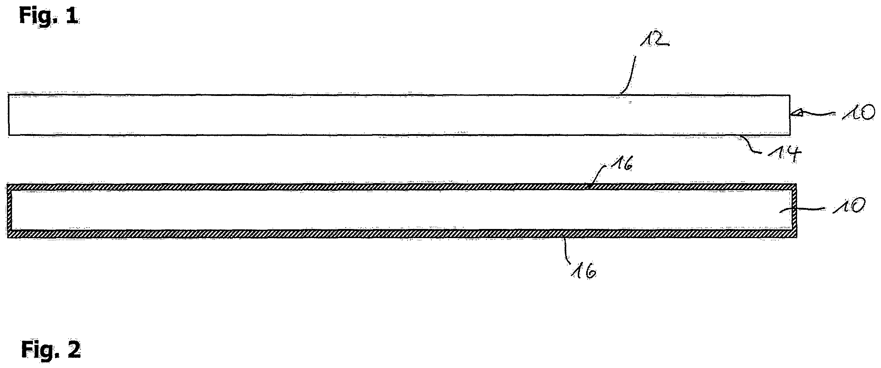

Figur 1 zeigt eine Kernschicht 10 für ein elektronisches Bauteil gemäß der Erfindung mit einer Oberseite 12 und einer Unterseite 14. Die Kernschicht 10 des dargestellten Ausführungsbeispiels besteht erfindungsgemäß aus einem Material mit einem geringen Wärmeausdehnungskoeffizienten, z.B. aus einer geeigneten Eisen-Nickel-Legierung. Es liegt jedoch auch im Bereich der Erfindung, als Kernschicht ein übliches elektrisch leitendes Material mit relativ hohem Wärmeausdehnungskoeffizienten, wie bspw. Kupfer, vorzusehen.

Die Kernschicht 10 wird in einem nächsten Schritt vollflächig mit einer dünnen ersten Schicht 16 aus elektrisch leitendem Material versehen, z.B. durch Plattieren (vgl. Figur 2). Die erste Schicht 16 wird auf der Oberseite 12 und/oder der Unterseite 14 des Substrats 10 aufgebracht. Das Aufbringen erfolgt bspw. durch Abscheiden (Aufplattieren, galvanisches/elektrochemisches Abscheiden) oder durch andere geeignete technische Maßnahmen (wie bspw. Aufsputtern, Vakuumabscheidung usw.), die dem Fachmann bekannt sind. Die Dicke der Kernschicht 10 liegt typischerweise in einem Bereich von ca. 100 µm bis ca. 500 µm. Besteht die Kernschicht aus bspw. Kupfer, so wird als weitere erste Schicht eine Schicht aus einem Material mit einem geringen Wärmeausdehnungskoeffizienten verwendet.

Alternativ kann eine vorgefertigte und im Handel erhältliche CIC-Schicht (CIC: Kupfer-Invar-Kupfer) verwendet werden, die durch Walzplattieren hergestellt ist. Typische Dicken einer solchen fertig erhältlichen CIC-Schicht sind 150 µm Invar® und jeweils 18 µm Kupfer.

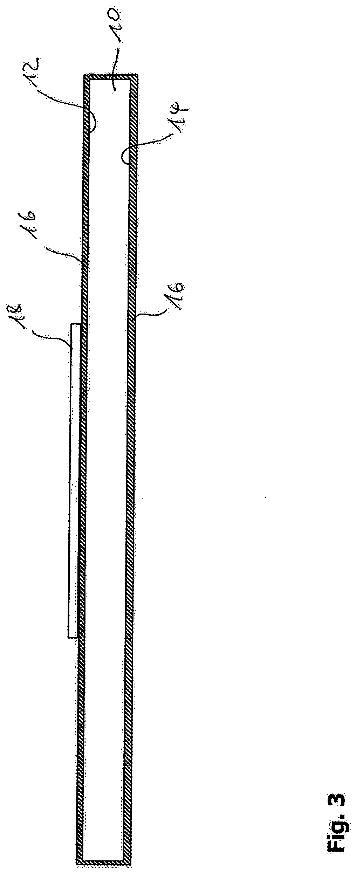

Figur 3 zeigt die Schichtabfolge der Figur 2 mit einer auf der ersten Schicht 16 aufgebrachten Bestückungsschicht 18. Die Bestückungsschicht 18 ist lediglich abschnittsweise auf der ersten Schicht 16 an einer zur Bestückung vorgesehenen Stelle aufgebracht (Bestückungsbereich A). Bei der Bestückungsschicht 18 handelt es sich beispielsweise um eine Schicht aus Edelmetall (wie Ag, Au, Sn o. dgl.), die in der Fachsprache auch "Kontaktierungsfläche" genannt wird. Die Bestückungsschicht wird durch dem Fachmann bekannte Verfahren aufgebracht (selektives Plattieren mit Fotolithographie).

Optional kann auf das Aufplattieren der ersten Schicht 16 verzichtet werden und die Bestückung direkt auf dem Substrat 10 bzw. der auf dem Substrat aufgebrachten Bestückungsschicht 18 vorgenommen werden. Es kann auch Anwendungen geben, in denen die Edelmetallschicht 18 nicht notwendig ist und direkt auf die Trägerschicht bestückt werden kann. Des weiteren können in jeder der genannten Varianten dem Fachmann an sich bekannte Haftvermittlerschichten vorgesehen sein, um den Bestückungsvorgang zu erleichtern.

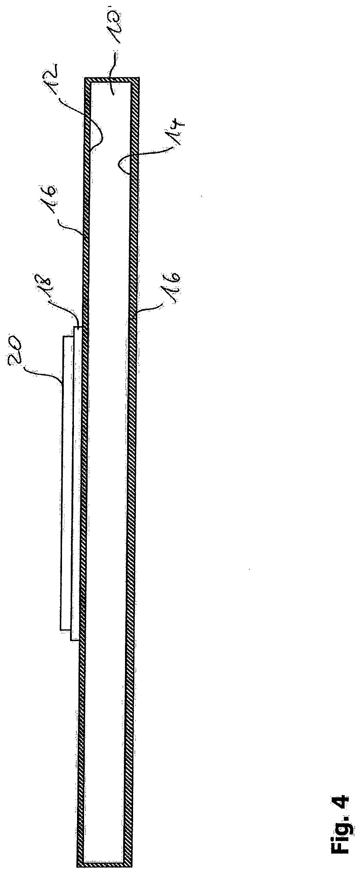

In einem nächsten Schritt erfolgt das Bestücken der Schichtabfolge der Figur 2 bzw. Figur 3 mit einem elektronischen Bauelement 20 (vgl. Figur 4). Bei dem elektronischen Bauelement 20 handelt es sich insbesondere um einen Leistungshalbleiter, wie bspw. einen MOSFET, IGBT, Dioden, usw. Die Aufbringung erfolgt in für den Fachmann an sich bekannter Art und Weise mittels bspw. Diffusionslöten, Leitkleben, normalem Löten usw. Im Falle von Silber-Sintern ist die voranstehend beschriebene Kontaktierungsfläche 18 notwendig.

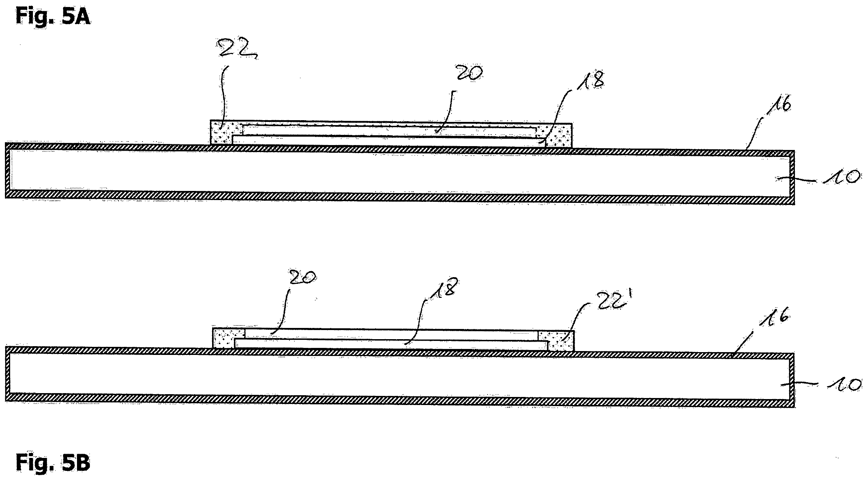

Das bestückte elektronische Bauelement 20 wird dann mit einem Verkapselungsmaterial 22 bzw. 22' verkapselt, wie dies in den Figuren 5A und 5B dargestellt ist. Das Verkapseln kann vollständig (Figur 5A) oder nur seitlich des Bauelements (Figur 5B) erfolgen. Als Verkapselungsmaterial kommen bspw. Epoxidharze in Betracht, die mittels Siebdruck, Schablonendruck oder Transfermoldverfahren aufgebracht werden. Aber auch andere organische Harze, die auch mit Füllstoffen bzgl. CTE und thermischer Leitfähigkeit optimiert werden, kommen in Betracht.

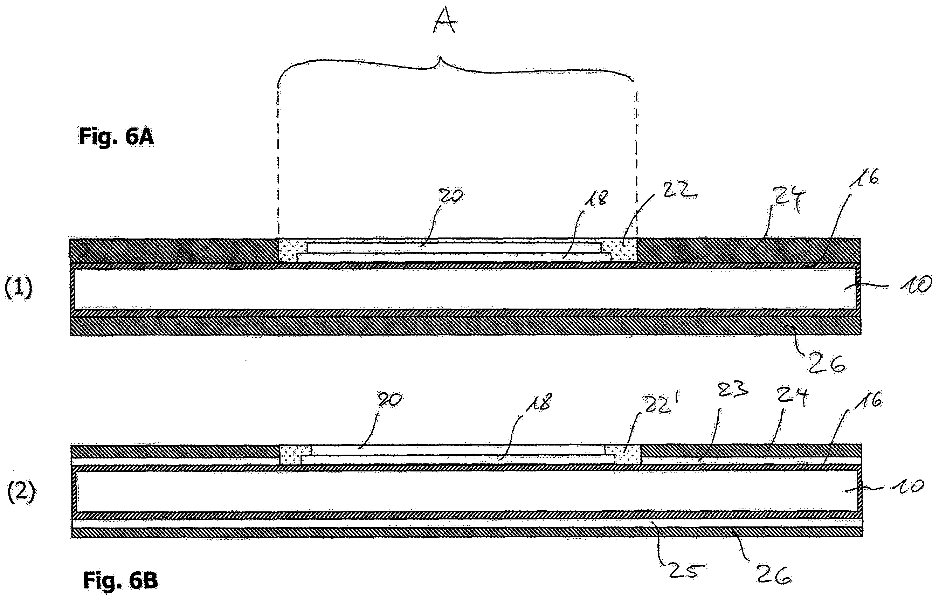

Zum Höhenausgleich wird seitlich des verkapselten Bauelements 20, d.h. um den durch die Verkapselung 22, 22' definierten Bestückungsbereich A, mindestens eine Ausgleichsschicht 24 aufgebracht, die im wesentlichen die gleiche Höhe hat wie die Verkapselung 22, 22' (Figur 6A). Ggf. kann zwischen der ersten Schicht 16 und der Ausgleichsschicht 24 eine Prepreglage 23 vorgesehen sein, wie dies in Figur 6B veranschaulicht ist. Letzteres bietet sich insbesondere bei dickeren elektronischen Bauelementen an. Aus Gründen der Symmetrie kann die Ausgleichsschicht beidseitig aufgebracht werden.

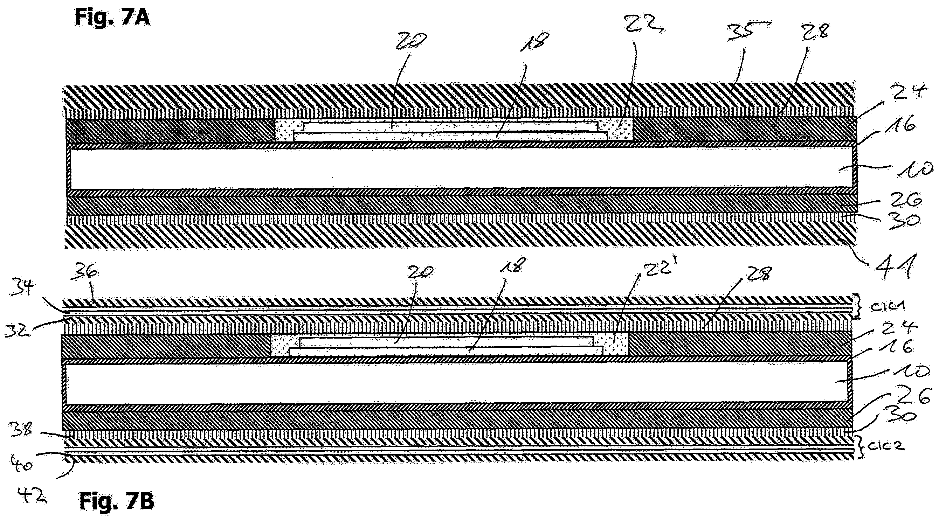

Die so entstandene Schichtabfolge wird mit jeweils einer Prepreglage 28, 30 und jeweils einer Schicht aus leitendem Material (wie z.B. Kupferfolien) 35, 41 verpresst (Figur 7A). Alternativ kann anstelle der Kupferfolien der Figur 7A bspw. auch jeweils eine CIC-Lage 32, 34, 36 bzw. 38, 40, 42 verwendet werden (wie dies im Ausführungsbeispiel der Figur 7B dargestellt ist), was eine weitere Anpassung des Wärmeausdehnungskoeffizienten erlaubt. Andere Materialien bzw. Legierungsabfolgen sind möglich, und selbstverständlich kann auch eine (nicht dargestellte) Mischform mit einer oberen CIC-Lage und einer unteren Kupferfolie realisiert werden; mit einer derartigen asymmetrischen Ausbildung kann eine gewollt gewölbte (konvexe bzw. konkave) Form des elektronischen Bauteils erzielt werden. Übliche Prepreg-Harz-Materialien weisen eine thermische Leitfähigkeit von ca. 0,2 bis 0,3 W/mK auf. Möglich sind jedoch auch Materialien mit einer Wärmeleitfähigkeit von 0,8 bis 5,0 W/mK (thermisch verbesserte Prepregschicht).

Aus dem beschriebenen Verfahrensablauf ergibt sich, dass das Material zur Verkapselung des Bauelements 20 in der Regel ein anderes ist, als das Material der elektrisch isolierenden Schicht 28 der Prepreg-Lagen.

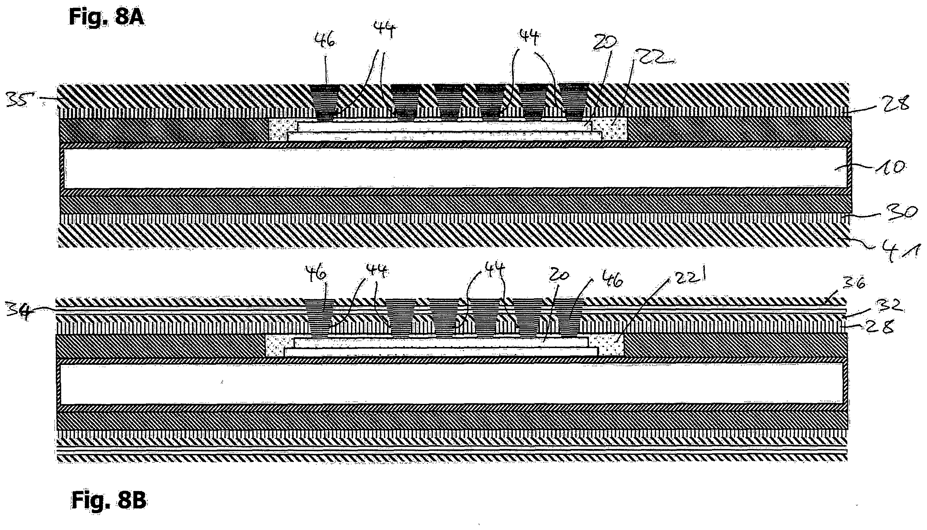

In einem folgenden Verfahrensschritt (vgl. Figuren 8A bzw. 8B) werden in einem Bereich oberhalb des elektronischen Bauelements 20 von der obersten leitenden Schicht 35, 36 her in dem Fachmann bekannter Art und Weise Durchkontaktierungslöcher 44 erzeugt. Anschließend wird in ebenfalls an sich bekannter Art und Weise eine dünne elektrisch leitende Schicht erzeugt. Diese Schicht kann bspw. durch chemisches Abscheiden von bspw. Kupfer erzeugt werden.

Dann wird auf der obersten Schicht 35, 36 eine Deckschicht 46 aus elektrisch leitendem Material aufgebracht. Bei dem elektrisch leitenden Material kann es sich bspw. wiederum um Kupfer handeln. Die Deckschicht 46 wird bspw. durch Galvanisieren derart aufgebracht, dass die Durchkontaktierungslöcher 44 vollständig gefüllt oder zumindest angefüllt werden, um eine gute Ankontaktierung des darunter liegenden elektronischen Bauelements 20 zu gewährleisten. Die Deckschicht kann auch auf der Unterseite (unterste Schicht 41 bzw. 42) aufgebracht werden. Durch das Ausfüllen der Durchkontaktierungslöcher geht auch eine Änderung der Materialzusammensetzung in den Schichten 34, 35 und 36 einher, die gezielt gesteuert werden kann, um den Wärmeausdehnungskoeffizienten auf eine gewünschte Größe einzustellen.

Es muss nicht weiter betont werden, dass die obersten Schichten 35, 36 keine durchgehenden leitenden Schichten sind (da sonst die gesamte Schaltungsanordnung) kurzgeschlossen wäre). Vielmehr werden diese Schichten - wie dies dem Fachmann ohne weiteres klar ist - gemäß einem vorgegebenen Schaltungsdesign strukturiert, was jedoch nicht Gegenstand der Erfindung ist und daher auch nicht weiter ausgeführt wird.

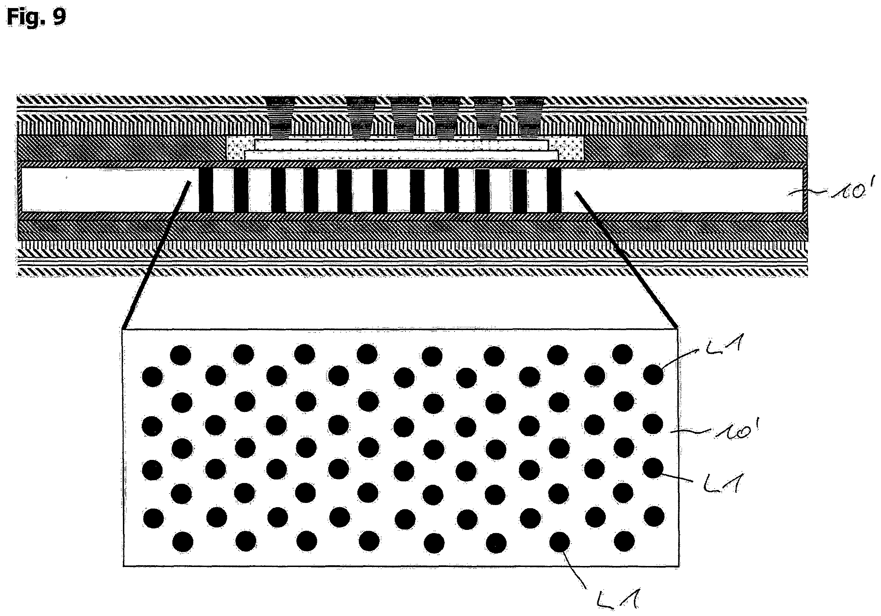

Figur 9 veranschaulicht eine Ausführungsvariante des elektronischen Bauteils der Figur 8B mit einer zumindest bereichsweise aus einem anderen Material bestehenden Kernschicht (10').

In der in Figur 9 dargestellten Ausführungsformvarianten ist ein Bereich unterhalb des Bauelements 20 der aus einer Eisen-Nickel-Legierung bestehenden Kernschicht 10' aus einem anderen Material mit einem höheren Wärmeausdehnungskoeffizienten und höherer elektrischer Leitfähigkeit gebildet. Diese Maßnahme gestattet eine feinere Abstimmung des Gesamtausdehnungskoeffizienten der Kernschicht zumindest in einem Bereich unterhalb des Bauelementes 20 auf dessen Ausdehnungskoeffizienten.

Die Ausgestaltung eines Bereiches der Kernschicht aus einem anderen Material lässt sich auf verschiedene Arten und Weisen erreichen. In dem dargestellten Ausführungsbeispiel ist ein Abschnitt der Kernschicht 10' unterhalb des Bestückungsbereichs A mit einer Vielzahl von Löchern L1 versehen, die im Zuge der Galvanisierung von auf der Kernschicht 10' aufgebrachten Kupferschichten mit Kupfer verfüllt wurden.

Die in Figur 9 dargestellte Ausführungsvariante verbindet einen geringen Wärmeausdehnungskoeffizienten in der X/Y-Ebene mit einer erhöhten thermischen und elektrischen Leitfähigkeit in der Z-Richtung.

Dem Fachmann wird somit erfindungsgemäß die Möglichkeit an die Hand gegeben, im Hinblick auf eine gewünschte Konfiguration die Parameter i) Wärmeausdehnungskoeffizient durch Auswahl des Materials für die Kernschicht und ii) bestimmen der Dickenverhältnisse der Kernschicht und der beidseitig aufgebrachten leitenden Schicht in Wechselwirkung mit iii) der Wahl der thermischen Leitfähigkeit in Z-Richtung durch einbringen eines anderen Materials in die Kernschicht aufeinander abzustimmen, um so den Wärmeausdehnungskoeffizienten des Bereichs unterhalb des elektronischen Bauelements möglichst gut an dessen Wärmeausdehnungskoeffizienten unter Erzielung einer möglichst guten thermischen Leitfähigkeit in Z-Richtung zu erzielen.

Selbstverständlich kann dieses Ziel auch durch ein umgekehrtes Vorgehen erreicht werden, nämlich indem die Kernschicht aus einem üblichen Material (insbesondere Kupfer) gewählt wird und die Anpassung durch Einbringen von Material mit geringem Wärmeausdehnungskoeffizienten in die Kernschicht erfolgt.

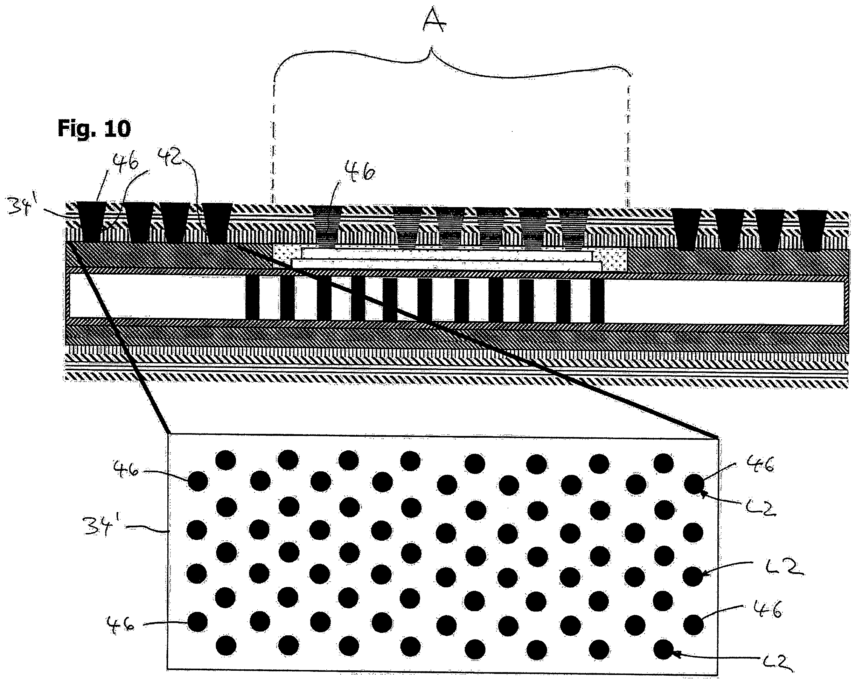

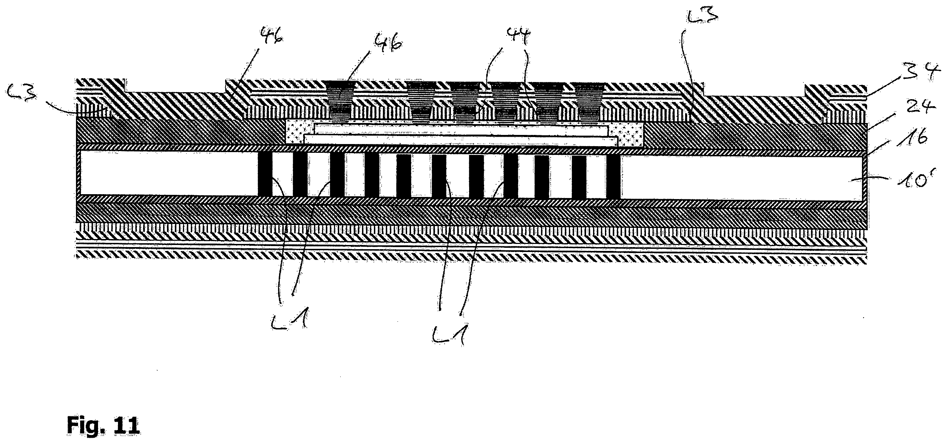

Figur 10 zeigt eine Weiterbildung des elektronischen Bauteils der Figur 9, bei dem zur weiteren Verbesserung der thermischen Leitfähigkeit auch außerhalb des Bestückungsbereich A mit Kupfer 46 gefüllte Löcher L2 als thermische Vias eingebracht sind. Anstelle dieser thermischen Vias kann die Verbesserung der thermischen Leitfähigkeit zur besseren Entwärmung über die Oberseite des elektronischen Bauteils durch Tiefenfräsen von Ausnehmungen L3, die anschließend galvanisch mit Kupfer 46 aufgefüllt werden, realisiert werden (vgl. Figur 11). Der Vorteil dieser Variante besteht darin, dass Tiefenfräsen kostengünstiger ist als Laserbohren.

Dieser erfindungsgemäße Aufbau eines elektronischen Bauteils gewährleistet eine stabile und thermisch hoch leistungsfähige Anordnung, die im Vergleich zu ähnlich leistungsfähigen Keramiksubstraten deutlich kostengünstiger herstellbar und kleiner dimensionierbar ist und eine höhere Bruchfestigkeit sowie eine deutlich längere Lebensdauer aufweist.

## Patentansprüche

1. Elektronisches Bauteil mit einer Trägerschicht (10, 16; 10') aus elektrisch leitfähigem Material, die in einem mindestens einen Bestückungsbereich (A) mit mindestens einem auf dem Bestückungsbereich (A) verkapselten (22) elektronischen Bauelement (20) bestückt ist und auf der neben dem Bestückungsbereich (A) mindestens eine Ausgleichsschicht (24) vorgesehen ist, auf der eine elektrisch isolierende, thermisch leitfähige Schicht (28) und mindestens eine elektrisch leitende Schicht (35; 32, 36) vorgesehen sind, wobei die Trägerschicht (10, 16; 10') zumindest in einem Abschnitt unterhalb des mindestens einen Bestückungsbereiches (A) einen Wärmeausdehnungskoeffizienten aufweist, der an den Wärmeausdehnungskoeffizienten des bestückten Bauelements (20) angepasst ist.

2. Elektronisches Bauteil nach Anspruch 1, bei dem die Trägerschicht eine Kernschicht (10; 10') aus elektrisch leitfähigem Material mit einer beidseitig aufgebrachten ersten Schicht (16) aus elektrisch leitendem Material aufweist.

3. Elektronisches Bauteil nach Anspruch 1 oder 2, bei dem eine Kernschicht der Trägerschicht (10') zumindest bereichsweise ein von dem Material der Kernschicht abweichendes Material aufweist.

4. Elektronisches Bauteil nach Anspruch 3, bei dem die Kernschicht (10') zumindest unterhalb des Bestückungsbereiches (A) zumindest bereichsweise ein von dem Material der Kernschicht abweichendes Material aufweist.

5. Elektronisches Bauteil nach Anspruch 3 oder 4, bei dem das zumindest bereichsweise andere Material aus in der Kernschicht ausgebildeten und mit galvanisch abgeschiedenem Kupfer gefüllten Löchern gebildet ist.

6. Elektronisches Bauteil nach einem der Ansprüche 1 bis 5, bei dem die mindestens eine elektrisch leitende Schicht aus einer Schichtabfolge (CIC1) umfassend eine erste elektrisch leitende Schicht (32), eine Zwischenschicht (34) aus einem Material mit einem geringen Wärmeausdehnungskoeffizienten und eine zweite elektrisch leitende Schicht (36) besteht.

7. Elektronisches Bauteil nach Anspruch 6, bei dem die Zwischenschicht (34) aus einem Material mit einem geringen Wärmeausdehnungskoeffizienten zumindest bereichsweise ein anderes Material aufweist.

8. Verfahren zum Herstellen eines elektronischen Bauteils nach Anspruch 1 mit den folgenden Schritten:
- Bereitstellen einer Trägerschicht (10; 10') aus einem Material mit einem an den Wärmeausdehnungskoeffizienten eines zu bestückenden elektronischen Bauelements (20) angepassten Wärmeausdehnungskoeffizienten mit einer Oberseite (12) und einer Unterseite (14),
- Bestücken mit mindestens einem elektronischen Bauelement (20),
- Verkapseln (22) des mindestens eines bestückten Bauelements (20),
- Aufbringen mindestens einer Ausgleichsschicht (24) nach dem Schritt des Verkapselns des mindestens eines bestückten Bauelements (20),
- Auflegen mindestens einer Prepreg-Schicht (28, 30) und mindestens einer elektrisch leitenden Schicht (35, 41; 32, 36, 38, 42), und
- Verpressen der so erzeugten Schichtabfolge.

9. Verfahren nach Anspruch 8, bei dem die Trägerschicht eine Kernschicht (10) aus einem Material mit einem geringen Wärmeausdehnungskoeffizienten umfasst, wobei das Verfahren vor dem Schritt des Bestückens noch den Schritt des Aufbringens einer ersten Schicht (16) aus leitendem Material auf die Oberseite (12) und/oder die Unterseite (14) des Substrats (10) umfasst.

10. Verfahren nach Anspruch 8, bei dem die Trägerschicht eine Kernschicht (10) aus einem elektrisch leitenden Material mit konventionellem Wärmeausdehnungskoeffizienten umfasst, wobei das Verfahren vor dem Schritt des Bestückens noch den Schritt des Aufbringens einer ersten Schicht (16) aus einem Material mit geringem Wärmeausdehnungskoeffizienten auf die Oberseite (12) und/oder die Unterseite (14) des Substrats (10) umfasst.

11. Verfahren nach einem der Ansprüche 8 bis 10, bei dem die Kernschicht (10') zumindest bereichsweise ein von dem Material der Kernschicht abweichendes Material aufweist, und/oder
mit dem Schritt des Einbringens von Durchkontaktierungen (44) von der obersten leitenden Schicht (35; 36) auf das Bauelement (20).

12. Verfahren nach einem der Ansprüche 8 bis 11, mit dem Schritt des Einbringens von Durchkontaktierungen (L2, 46) außerhalb des Bestückungsbereichs (A).

13. Verfahren nach einem der Ansprüche 8 bis 12, mit den weiteren Schritten:
- Einbringen mindestens einer Ausnehmung (L3) neben dem Bestückungsbereich (A),
- Auffüllen der mindestens einen Ausnehmung (L3) mit leitendem Material (46).

14. Verfahren nach Anspruch 13, bei dem die mindestens eine Ausnehmung (L3) mittels Laserbohren und anschließendem galvanischem Aufplattieren erzeugt wird oder bei dem die mindestens eine Ausnehmung (L3) mittels Tiefenfräsen und anschließendem galvanischen Aufplattieren erzeugt wird.

15. Leiterplatte mit einem elektronischen Bauteil nach einem der Ansprüche 1 bis 7.

## Claims

1. Electronic device comprising a carrier layer (10, 16; 10') composed of electrically conductive material, said carrier layer, in an at least one placement region (A), being equipped with at least one electronic component (20) encapsulated (22) on the placement region (A) and at least one compensation layer (24) being provided on said carrier layer alongside the placement region (A), an electrically insulating, thermally conductive layer (28) and at least one electrically conductive layer (35; 32, 36) being provided on said at least one compensation layer, wherein the carrier layer (10, 16; 10') at least in a portion below the at least one placement region (A), has a coefficient of thermal expansion that is adapted to the coefficient of thermal expansion of the placed component (20).

2. Electronic device according to Claim 1, wherein the carrier layer comprises a core layer (10; 10') composed of electrically conductive material with a first layer (16) composed of electrically conductive material applied on both sides.

3. Electronic device according to Claim 1 or 2 wherein a core layer of the carrier layer (10') at least regionally comprises a material deviating from the material of the core layer.

4. Electronic device according to Claim 3, wherein the core layer (10'), at least below the placement region (A) at least regionally comprises a material deviating from the material of the core layer.

5. Electronic device according to Claim 3 or 4 wherein the at least regionally different material is formed from holes that are implemented in the core layer and are filled with electrodeposited copper.

6. Electronic device according to any of Claims 1 to 5, wherein the at least one electrically conductive layer consists of a layer sequence (CIC1) comprising a first electrically conductive layer (32), an intermediate layer (34) composed of a material having a low coefficient of thermal expansion and a second electrically conductive layer (36).

7. Electronic device according to Claim 6, wherein the intermediate layer (34) composed of a material having a low coefficient of thermal expansion at least regionally comprises a different material.

8. Method for producing an electronic device according to Claim 1 comprising the following steps:
- providing a carrier layer (10; 10') composed of a material having a coefficient of thermal expansion adapted to the coefficient of thermal expansion of an electronic component (20) to be placed, having a top side (12) and underside (14),
- equipping with at least one electronic component (20),
- encapsulating (22) the at least one placed component (20),
- applying at least one compensation layer (24) after the step of encapsulating the at least one placed component (20),
- applying at least one prepreg layer (28, 30) and at least one electrically conductive layer (35, 41; 32, 36, 38, 42), and
- pressing the layer sequence thus produced.

9. Method according to Claim 8, wherein the carrier layer comprises a core layer (10) composed of a material having a low coefficient of thermal expansion, wherein the method going before the step of equipping, additionally comprises the step of applying a first layer (16) composed of conductive material to the top side (12) and/or the underside (14) of the substrate (10).

10. Method according to Claim 8, wherein the carrier layer comprises a core layer (10) composed of an electrically conductive material having a conventional coefficient of thermal expansion, wherein the method, before the step of equipping, additionally comprises the step of applying a first layer (16) composed of a material having a low coefficient of thermal expansion to the top side (12) and/or the underside (14) of the substrate (10).

11. Method according to any of Claims 8 to 10, wherein the core layer (10') at least regionally comprises a material deviating from the material of the core layer, and/or
comprising the step of introducing plated-through holes (44) from the topmost conductive layer (35; 36) to the component (20).

12. Method according to any of Claims 8 to 11, comprising the step of introducing plated-through holes (L2, 46) outside the placement region (A).

13. Method according to any of Claims 8 to 12, comprising the further steps of:
- introducing at least one cutout (L3) alongside the placement region (A),
- filling the at least one cutout (L3) with conductive material (46).

14. Method according to Claim 13, wherein the at least one cutout (L3) is produced by means of laser drilling and subsequent electroplating, or wherein the at least one cutout (L3) is produced by means of deep milling and subsequent electroplating.

15. Printed circuit board comprising an electronic device according to any of Claims 1 to 7.

## Revendications

1. Composant électronique comportant une couche porteuse (10, 16 ; 10') en matériau électriquement conducteur, qui, dans au moins une zone d'équipement (AS), est équipée d'au moins un élément structurel électronique (20) encapsulé (22) sur la zone d'équipement (A), et sur laquelle est prévue, à côté de la zone d'équipement (A), au moins une couche de compensation (24) sur laquelle sont prévues au moins une couche (28) électriquement isolante et thermiquement conductrice et au moins une couche électriquement conductrice (35 ; 32, 36),
dans lequel la couche porteuse (10, 16 ; 10') comprend, au moins dans une portion au-dessous de ladite au moins une zone d'équipement (A), un coefficient de dilatation thermique qui est adapté au coefficient de dilatation thermique de l'élément structurel équipé (20).

2. Composant électronique selon la revendication 1, dans lequel la couche porteuse présente une couche formant noyau (10 ; 10') en un matériau électriquement conducteur avec une première couche (16) en matériau électriquement conducteur déposée de part et d'autre.

3. Composant électronique selon la revendication 1 ou 2, dans lequel une couche formant noyau de la couche porteuse (10') présente au moins localement un matériau qui diffère du matériau de la couche formant noyau.

4. Composant électronique selon la revendication 3, dans lequel la couche formant noyau (10') présente au moins au-dessous de la zone d'équipement (A) au moins localement un matériau qui diffère du matériau de la couche formant noyau.

5. Composant électronique selon la revendication 3 ou 4, dans lequel l'autre matériau prévu au moins localement est formé par des trous ménagés dans la couche formant noyau et remplis de cuivre déposé par voie galvanique.

6. Composant électronique selon l'une des revendications 1 à 5, dans lequel ladite au moins une couche électriquement conductrice consiste en une succession de couches (CIC1) comprenant une première couche (32) électriquement conductrice, une couche intermédiaire (34) en un matériau à faible coefficient de dilatation thermique, et une seconde couche (36) électriquement conductrice.

7. Composant électronique selon la revendication 6, dans lequel la couche intermédiaire (34) en un matériau à faible coefficient de dilatation thermique présente au moins localement un autre matériau.

8. Procédé de réalisation d'un composant électronique selon la revendication 1, comprenant les étapes suivantes consistant à :
- fournir une couche porteuse (10 ; 10') en un matériau présentant un coefficient de dilatation thermique adapté au coefficient de dilatation thermique d'un élément structurel électronique (20) à équiper, avec une face supérieure (12) et une face inférieure (14),
- l'équiper d'au moins un composant électronique (20),
- encapsuler (22) ledit au moins un élément structurel (20) équipé,
- appliquer au moins une couche de compensation (24) après l'étape d'encapsulage dudit au moins un élément structurel (20) équipé,
- poser au moins une couche pré-imprégnée (28, 30) et au moins une couche électriquement conductrice (35, 41 ; 32, 36, 38, 42) et
- comprimer la succession de couches ainsi réalisée.

9. Procédé selon la revendication 8, dans lequel la couche porteuse comprend une couche formant noyau (10) en un matériau présentant un faible coefficient de dilatation thermique, le procédé comprenant, avant l'étape d'équipement, encore l'étape d'application d'une première couche (16) en matériau conducteur sur la face supérieure (12) et/ou sur la face inférieure (14) du substrat (10).

10. Procédé selon la revendication 8, dans lequel la couche porteuse comprend une couche formant noyau (10) en un matériau électriquement conducteur à coefficient de dilatation thermique classique, le procédé comprenant, avant l'étape d'équipement, encore l'étape d'application d'une première couche (16) en matériau à faible coefficient de dilatation thermique sur la face supérieure (12) et/ou sur la face inférieure (14) du substrat (10).

11. Procédé selon l'une des revendications 8 à 10, dans lequel la couche formant noyau (10') comprend au moins localement un matériau qui diffère du matériau de la couche formant noyau, et/ou
comprenant l'étape de réalisation de trous métallisés (44) depuis la couche conductrice supérieure (35 ; 36) sur l'élément structurel (20).

12. Procédé selon l'une des revendications 8 à 11, comprenant l'étape de réalisation de trous métallisés (L2, 46) à l'extérieur de la zone d'équipement (A).

13. Procédé selon l'une des revendications 8 à 12, comprenant les autres étapes consistant à :
- réaliser au moins un évidement (L3) à côté de la zone d'équipement (A),
- remplir ledit au moins un évidement (L3) avec le matériau conducteur (46).

14. Procédé selon la revendication 13, dans lequel on réalise ledit au moins un évidement (L3) par perçage au laser et ensuite par plaquage galvanique, ou dans lequel on réalise ledit au moins un évidement (L3) par fraisage profond et ensuite par plaquage galvanique.

15. Carte à circuits imprimés pourvue d'un composant électronique selon l'une des revendications 1 à 7.
